(19) **Europäisches Patentamt European Patent Office Office européen des brevets**

(11) **EP 4 495 672 A1**

(12) **EUROPEAN PATENT APPLICATION**
published in accordance with Art. 153(4) EPC

(43) Date of publication:
**22.01.2025 Bulletin 2025/04**

(21) Application number: **23770612.2**

(22) Date of filing: **09.03.2023**

(51) International Patent Classification (IPC):
***G02B 27/02*** *(2006.01)*

(52) Cooperative Patent Classification (CPC):
**G02B 3/00; G02B 5/00; G02B 5/08; G02B 5/30; G02B 13/00; G02B 17/08; G02B 27/02; G02C 7/00; G02F 1/13; G02F 1/1335; G02F 1/13363; G02F 1/1337; G09F 9/00; H04N 5/64; H04N 5/66;**
(Cont.)

(86) International application number:
**PCT/JP2023/008963**

(87) International publication number:
**WO 2023/176656 (21.09.2023 Gazette 2023/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.03.2022   JP 2022039285**
**14.03.2022   JP 2022039286**
**10.05.2022   JP 2022077631**
**10.05.2022   JP 2022077632**
**10.05.2022   JP 2022077633**
**10.05.2022   JP 2022077634**
**10.05.2022   JP 2022077657**
**10.05.2022   JP 2022077658**
**10.05.2022   JP 2022077659**
**10.05.2022   JP 2022077676**
**10.05.2022   JP 2022077677**
**10.05.2022   JP 2022077678**
**10.05.2022   JP 2022077679**
**28.12.2022   JP 2022212095**

(71) Applicant: **Nitto Denko Corporation Ibaraki-shi, Osaka 567-8680 (JP)**

(72) Inventors:
• **KOJIMA Tadashi**
**Ibaraki-shi, Osaka 567-8680 (JP)**
• **GOTO Shusaku**
**Ibaraki-shi, Osaka 567-8680 (JP)**

(74) Representative: **Hoffmann Eitle**
**Patent- und Rechtsanwälte PartmbB**
**Arabellastraße 30**
**81925 München (DE)**

(54) **LENS UNIT AND LAMINATED FILM**

(57)    Provided is a lens unit that can achieve a reduction in weight of a pair of VR goggles and an improvement in viewability thereof. The lens unit according to an embodiment of the present invention is a lens unit to be used in a display system configured to display an image to a user, the lens unit including: a reflection-type polarizing member configured to reflect light, which has been emitted toward a front side from a display surface of a display element configured to display the image, and has passed through a polarizing member and a first λ/4 member; a first lens portion arranged on an optical path between the display element and the reflection-type polarizing member; a half mirror arranged between the display element and the first lens portion, the half mirror being configured to transmit the light emitted from the display element and to reflect the light reflected by the reflection-type polarizing member toward the reflection-type polarizing member; a second lens portion arranged the a front side of the reflection-type polarizing member; a second λ/4 member arranged on an optical path between the half mirror and the reflection-type polarizing member; and a first protective member and a second protective member each arranged on the optical path between the half mirror and the reflection-type polarizing member, wherein the first protective member and the second protective member are arranged to face each other through a space, and wherein the first protective member and the second protective member each have a maximum value for a 5° specular reflectance spectrum in a wavelength range of from 420 nm to 680 nm of 1.2% or less.

FIG. 1

(52) Cooperative Patent Classification (CPC): (Cont.)
**H04N 13/344; H04N 13/346; H05B 33/02;
H05B 33/10; H05B 33/24; H10K 50/00;
H10K 50/858; H10K 50/86; H10K 59/00;
H10K 59/10**

**Description**

Technical Field

The present invention relates to a lens unit and a laminate film.

Background Art

Image display apparatus typified by a liquid crystal display apparatus and an electroluminescence (EL) display apparatus (e.g., an organic EL display apparatus) have been rapidly gaining more widespread use. In the image display apparatus, an optical member, such as a polarizing member or a retardation member, has been generally used for achieving image display and improving the performance of the image display (see, for example, Patent Literature 1).
In recent years, new applications of the image display apparatus have been developed. For example, a pair of goggles (VR goggles) with a display for achieving virtual reality (VR) has started to be commercialized. A reduction in weight of the pair of VR goggles, an improvement in viewability thereof, and the like have been desired because an investigation has been made on the utilization of the pair of VR goggles in various fields. The weight reduction may be achieved by, for example, thinning a lens to be used in the pair of VR goggles. Meanwhile, the development of an optical member suitable for a display system using a thin lens has also been desired. For example, an optical member that can solve a problem of reflection that may occur in the pair of VR goggles has been desired for improving the viewability.

Citation List

Patent Literature

[PTL 1] JP 2021-103286 A

Summary of Invention

Technical Problem

In view of the foregoing, a primary object of the present invention is to provide a lens unit that can achieve a reduction in weight of a pair of VR goggles and an improvement in viewability thereof.

Solution to Problem

1. According to one embodiment of the present invention, there is provided a lens unit to be used in a display system configured to display an image to a user, the lens unit including: a reflection-type polarizing member configured to reflect light, which has been emitted toward a front side from a display surface of a display element configured to display the image, and has passed through a polarizing member and a first $\lambda/4$ member; a first lens portion arranged on an optical path between the display element and the reflection-type polarizing member; a half mirror arranged between the display element and the first lens portion, the half mirror being configured to transmit the light emitted from the display element and to reflect the light reflected by the reflection-type polarizing member toward the reflection-type polarizing member; a second lens portion arranged on the front side of the reflection-type polarizing member; a second $\lambda/4$ member arranged on an optical path between the half mirror and the reflection-type polarizing member; and a first protective member and a second protective member each arranged on the optical path between the half mirror and the reflection-type polarizing member, wherein the first protective member and the second protective member are arranged to face each other through a space, and wherein the first protective member and the second protective member each have a maximum value for a 5° specular reflectance spectrum in a wavelength range of from 420 nm to 680 nm of 1.2% or less.

2. In the lens unit according to the above-mentioned item 1, the first protective member and the second protective member may each have a 5° specular reflectance at a wavelength of 450 nm of 0.3% or less.

3. In the lens unit according to the above-mentioned item 1 or 2, the first protective member and the second protective member may each have a 5° specular reflectance at a wavelength of 600 nm of 0.3% or less.

4. In the lens unit according to any one of the above-mentioned items 1 to 3, the first protective member and the second protective member may each have a surface smoothness of 0.5 arcmin or less.

5. In the lens unit according to any one of the above-mentioned items 1 to 4, the second $\lambda/4$ member may satisfy Re (450) <Re (550).

6. The lens unit according to any one of the above-mentioned items 1 to 5 may include a first laminate portion including the second $\lambda/4$ member and the first protective member; and a second laminate portion including the reflection-type polarizing member and the second protective member.

7. In the lens unit according to the above-mentioned item 6, the second laminate portion may include an absorption-type polarizing member arranged between the reflection-type polarizing member and the second lens portion.

8. In the lens unit according to the above-mentioned item 6 or 7, the second laminate portion may include a third $\lambda/4$ member arranged between the reflection-type polarizing member and the second lens portion.

9. In the lens unit according to the above-mentioned item 8, the third $\lambda/4$ member may satisfy Re(450)<Re(550).

10. According to one embodiment of the present invention, there is provided a laminate film to be used in a display method, the display method including the steps of: passing light representing an image, which has been emitted through a polarizing member and a first $\lambda/4$ member, through a half mirror and a first lens portion; passing the light, which has passed through the half mirror and the first lens portion, through a second $\lambda/4$ member; reflecting the light, which has passed through the second $\lambda/4$ member, toward the half mirror with a reflection-type polarizing member; enabling the light, which has been reflected by the reflection-type polarizing member and the half mirror, to penetrate through the reflection-type polarizing member with the second $\lambda/4$ member; and passing the light, which has penetrated through the reflection-type polarizing member, through a second lens portion, wherein the laminate film is arranged on an optical path between the half mirror and the reflection-type polarizing member, wherein the laminate film is brought into contact with a space formed between the first lens portion and the second lens portion, and wherein the laminate film has a maximum value for a 5° specular reflectance spectrum of 1.2% or less in a wavelength range of from 420 nm to 680 nm.

Advantageous Effects of Invention

According to the lens unit of the embodiment of the present invention, the reduction in weight of the pair of VR goggles and the improvement in viewability thereof can be achieved.

Brief Description of Drawings

FIG. **1** is a schematic view for illustrating the schematic configuration of a display system according to one embodiment of the present invention.

FIG. **2** is a schematic sectional view for illustrating an example of details of a lens unit in the display system illustrated in FIG. **1.**

FIG. **3** is a schematic sectional view for illustrating the schematic configuration of a laminate film according to one embodiment of the present invention.

FIG. **4** is a schematic perspective view for illustrating an example of a multilayer structure in a reflection-type polarizing film.

FIG. **5** is a graph showing a 5° specular reflectance spectrum of a laminate film of each of Example 1 and Comparative Example 1.

FIG. **6(a),** FIG. **6(b),** and FIG. **6(c)** are each a photograph showing results of appearance evaluation.

FIG. **7(a),** FIG. **7(b),** FIG. **7(c),** and FIG. **7(d)** are each a photograph showing results of appearance evaluation.

Description of Embodiments

Embodiments of the present invention are described below with reference to the drawings. However, the present invention is not limited to these embodiments. For clearer illustration, some widths, thicknesses, shapes, and the like of respective portions may be schematically illustrated in the drawings in comparison to the embodiments. However, the widths, the thicknesses, the shapes, and the like are each merely an example, and do not limit the understanding of the present invention. In addition, in the drawings, the same components or equivalent components may be denoted by the same reference symbols, and duplicate descriptions thereof may be omitted.

(Definitions of Terms and Symbols)

The definitions of terms and symbols used herein are as described below.

(1) Refractive Indices (nx, ny, and nz)

"nx" represents a refractive index in a direction in which an in-plane refractive index is maximum (that is, slow axis direction), "ny" represents a refractive index in a direction perpendicular to a slow axis in a plane (that is, fast axis direction), and "nz" represents a refractive index in a thickness direction.

(2) In-plane Retardation (Re)

"Re($\lambda$)" refers to an in-plane retardation measured at 23°C with light having a wavelength of $\lambda$ nm. For example, "Re(550)" refers to an in-plane retardation measured at 23°C with light having a wavelength of 550 nm. The Re($\lambda$) is determined from the equation "Re($\lambda$)=(nx-ny)×d" when the thickness of a layer (film) is represented by "d" (nm).

(3) Thickness Direction Retardation (Rth)

"Rth($\lambda$)" refers to a thickness direction retardation measured at 23°C with light having a wavelength of $\lambda$ nm. For example, "Rth(550)" refers to a thickness direction retardation measured at 23°C with light having a wavelength of 550 nm. The Rth($\lambda$) is determined from the equation "Rth($\lambda$)=(nx-nz)×d" when the thickness of a layer (film) is represented by "d" (nm).

(4) Nz Coefficient

An Nz coefficient is determined from the equation "Nz=Rth/Re".

(5) Angle

When reference is made to an angle herein, the angle encompasses both angles in a clockwise direction and a counterclockwise direction with respect to a reference direction. Accordingly, for example, the term "45°" means ±45°.

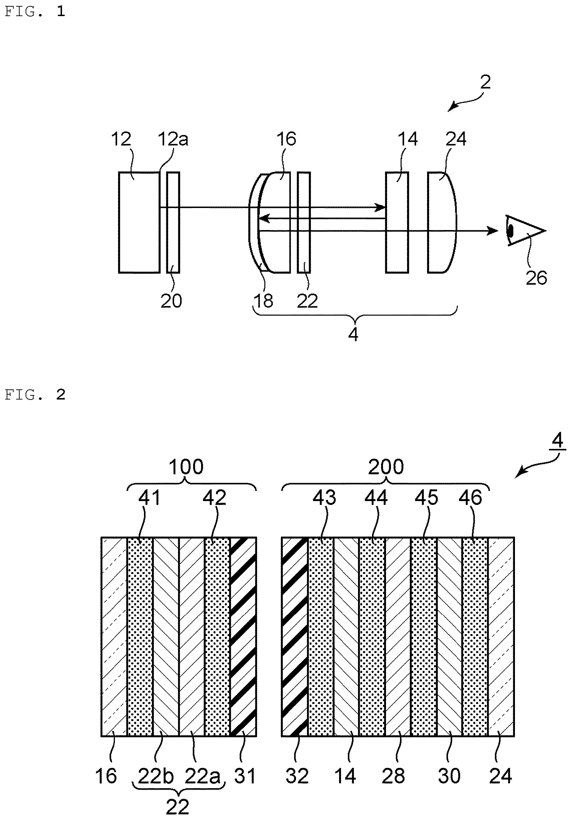

FIG. **1** is a schematic view for illustrating the schematic configuration of a display system according to one embodiment of the present invention. The arrangement, shapes, and the like of the respective constituents of a display system **2** are schematically illustrated in FIG. **1**. The display system **2** includes: a display element **12**; a reflection-type polarizing member **14**; a first lens portion **16**; a half mirror **18**; a first retardation member **20**; a second retardation member **22**; and a second lens portion **24**. The reflection-type polarizing member **14** is arranged on a front side of the display element **12**, that is, on the display surface **12a** side thereof, and can reflect light emitted from the display element **12**. The first lens portion **16** is arranged on an optical path between the display element **12** and the reflection-type polarizing member **14**, and the half mirror **18** is arranged between the display element **12** and the first lens portion **16**. The first retardation member **20** is arranged on an optical path between the display element **12** and the half mirror **18**, and the second retardation member **22** is arranged on an optical path between the half mirror **18** and the reflection-type polarizing member **14**.
The half mirror and the constituents arranged on the front side thereof (in the illustrated example, the half mirror **18**, the first lens portion **16**, the second retardation member **22**, the reflection-type polarizing member **14**, and the second lens portion **24**) are sometimes collectively referred to as "lens unit (lens unit **4**)."
The display element **12** is, for example, a liquid crystal display or an organic EL display, and has a display surface **12a** for displaying an image. The light to be emitted from the display surface **12a** passes through, for example, a polarizing member (typically, a polarizing film) that may be incorporated into the display element **12** to be emitted as first linearly polarized light.

The first retardation member **20** includes a first λ/4 member that can convert the first linearly polarized light, which has entered the first retardation member **20,** into first circularly polarized light. When the first retardation member is free of any member other than the first λ/4 member, the first retardation member may correspond to the first λ/4 member. The first retardation member **20** may be arranged integrally with the display element **12.**

The half mirror **18** transmits the light emitted from the display element **12,** and reflects the light reflected by the reflection-type polarizing member **14** toward the reflection-type polarizing member **14.** The half mirror **18** is arranged integrally with the first lens portion **16.**

The second retardation member **22** includes a second λ/4 member that can cause the light, which has been reflected by the reflection-type polarizing member **14** and the half mirror **18,** to penetrate through the reflection-type polarizing member **14.** When the second retardation member is free of any member other than the second λ/4 member, the second retardation member may correspond to the second λ/4 member. The second retardation member **22** may be arranged integrally with the first lens portion **16.**

The first circularly polarized light emitted from the first λ/4 member in the first retardation member **20** passes through the half mirror **18** and the first lens portion **16,** and is converted into second linearly polarized light by the second λ/4 member in the second retardation member **22.** The second linearly polarized light emitted from the second λ/4 member is reflected toward the half mirror **18** without penetrating through the reflection-type polarizing member **14.** At this time, the polarization direction of the second linearly polarized light that has entered the reflection-type polarizing member **14** is the same direction as that of the reflection axis of the reflection-type polarizing member **14.** Accordingly, the second linearly polarized light that has entered the reflection-type polarizing member **14** is reflected by the reflection-type polarizing member **14.**

The second linearly polarized light reflected by the reflection-type polarizing member **14** is converted into second circularly polarized light by the second λ/4 member in the second retardation member **22,** and the second circularly polarized light emitted from the second λ/4 member passes through the first lens portion **16,** and is reflected by the half mirror **18.** The second circularly polarized light reflected by the half mirror **18** passes through the first lens portion **16,** and is converted into third linearly polarized light by the second λ/4 member in the second retardation member **22.** The third linearly polarized light penetrates through the reflection-type polarizing member **14.** At this time, the polarization direction of the third linearly polarized light that has entered the reflection-type polarizing member **14** is the same direction as that of the transmission axis of the reflection-type polarizing member **14.** Accordingly, the third linearly polarized light that has entered the reflection-type polarizing member **14** penetrates through the reflection-type polarizing member **14.**

The light that has penetrated through the reflection-type polarizing member **14** passes through the second lens portion **24** to enter an eye **26** of a user.

For example, the absorption axis of the polarizing member in the display element **12** and the reflection axis of the reflection-type polarizing member **14** may be arranged substantially parallel to each other, or may be arranged substantially perpendicular to each other. An angle formed by the absorption axis of the polarizing member in the display element **12** and the slow axis of the first λ/4 member in the first retardation member **20** is, for example, from 40° to 50°, and may be from 42° to 48°, or may be about 45°. An angle formed by the absorption axis of the polarizing member in the display element **12** and the slow axis of the second λ/4 member in the second retardation member **22** is, for example, from 40° to 50°, and may be from 42° to 48°, or may be about 45°.

The in-plane retardation Re(550) of the first λ/4 member is, for example, from 100 nm to 190 nm, and may be from 110 nm to 180 nm, may be from 130 nm to 160 nm, or may be from 135 nm to 155 nm. The first λ/4 member preferably shows such a reverse wavelength dispersion characteristic that its retardation value increases with an increase in wavelength of measurement light. The ratio "Re(450)/Re(550)" of the first λ/4 member is, for example, 0.75 or more and less than 1, and may be 0.8 or more and 0.95 or less.

The in-plane retardation Re(550) of the second λ/4 member is, for example, from 100 nm to 190 nm, and may be from 110 nm to 180 nm, may be from 130 nm to 160 nm, or may be from 135 nm to 155 nm. The second λ/4 member preferably shows such a reverse wavelength dispersion characteristic that its retardation value increases with an increase in wavelength of measurement light. The ratio "Re(450)/Re(550)" of the second λ/4 member is, for example, 0.75 or more and less than 1, and may be 0.8 or more and 0.95 or less.

In the lens unit **4,** a space may be formed between the first lens portion **16** and the second lens portion **24.** In this case, a member to be arranged between the first lens portion **16** and the second lens portion **24** is preferably arranged integrally with one of the first lens portion **16** or the second lens portion **24.** For example, the member to be arranged between the first lens portion **16** and the second lens portion **24** is preferably integrated with one of the first lens portion **16** or the second lens portion **24** via an adhesion layer. According to such form, for example, the handleability of each member can be excellent. The adhesion layer may be formed from an adhesive, or may be formed from a pressure-sensitive adhesive. Specifically, the adhesion layer may be an adhesive layer or a pressure-sensitive adhesive layer. The thickness of the adhesion layer is, for example, from 0.05 μm to 30 μm.

FIG. **2** is a schematic sectional view for illustrating an example of details of a lens unit in the display system illustrated in FIG. **1.** Specifically, FIG. **2** is an illustration of a first lens portion, a second lens portion, and members to be arranged therebetween. The lens unit **4** includes the first lens portion **16**, a first laminate portion **100** arranged adjacent to the first lens portion **16**, the second lens portion **24**, and a second laminate portion **200** arranged adjacent to the second lens portion **24**. In the example illustrated in FIG. **2**, the first laminate portion **100** and the second laminate portion **200** are arranged so as to be spaced apart from each other. A half mirror may be arranged integrally with the first lens portion **16**, though the half mirror is not shown.

The first laminate portion **100** includes: the second retardation member **22**; and an adhesion layer (e.g., a pressure-sensitive adhesive layer) **41** arranged between the first lens portion **16** and the second retardation member **22**, and is arranged integrally with the first lens portion **16** via the adhesion layer **41**. The first laminate portion **100** further includes a first protective member **31** arranged on the front side of the second retardation member **22**. The first protective member **31** is laminated on the second retardation member **22** via an adhesion layer (e.g., a pressure-sensitive adhesive layer) **42**. The first protective member **31** may be positioned on the outermost surface of the first laminate portion **100**.

In the example illustrated in FIG. **2**, the second retardation member **22** includes a member (so-called positive C-plate) **22b** whose refractive index characteristic may show the relationship of nz>nx=ny in addition to a second λ/4 member **22a**. The second retardation member **22** has a laminated structure of the second λ/4 member **22a** and the positive C-plate **22b**. When the positive C-plate is used, light leakage (e.g., light leakage in an oblique direction) can be prevented. As illustrated in FIG. **2**, in the second retardation member **22**, it is preferred that the second λ/4 member **22a** be positioned on the front side of the positive C-plate **22b**. The second λ/4 member **22a** and the positive C-plate **22b** are laminated via, for example, an adhesive layer (not shown).

The refractive index characteristic of the second λ/4 member preferably shows the relationship of nx>ny≥nz. The equation "ny=nz" as used herein encompasses not only a case in which the ny and the nz are completely equal to each other but also a case in which the ny and the nz are substantially equal to each other. Accordingly, the ny may be less than the nz to the extent that the effects of the present invention are not impaired. The Nz coefficient of the second λ/4 member is preferably from 0.9 to 3, more preferably from 0.9 to 2.5, still more preferably from 0.9 to 1.5, particularly preferably from 0.9 to 1.3.

The second λ/4 member is formed from any appropriate material that may satisfy the above-mentioned characteristics. The second λ/4 member may be, for example, a stretched film of a resin film or an alignment fixed layer of a liquid crystal compound.

A resin to be incorporated into the resin film is, for example, a polycarbonate-based resin, a polyester carbonate-based resin, a polyester-based resin, a polyvinyl acetal-based resin, a polyarylate-based resin, a cyclic olefin-based resin, a cellulose-based resin, a polyvinyl alcohol-based resin, a polyamide-based resin, a polyimide-based resin, a polyether-based resin, a polystyrene-based resin, or an acrylic resin. Those resins may be used alone or in combination thereof. A method for the combination is, for example, blending or copolymerization. When the second λ/4 member shows a reverse wavelength dispersion characteristic, a resin film containing a polycarbonate-based resin or a polyester carbonate-based resin (hereinafter sometimes simply referred to as "polycarbonate-based resin") may be suitably used.

Any appropriate polycarbonate-based resin may be used as the polycarbonate-based resin. For example, the polycarbonate-based resin includes a structural unit derived from a fluorene-based dihydroxy compound, a structural unit derived from an isosorbide-based dihydroxy compound, and a structural unit derived from at least one dihydroxy compound selected from the group consisting of: an alicyclic diol; an alicyclic dimethanol; di-, tri-, or polyethylene glycol; and an alkylene glycol or a spiroglycol. The polycarbonate-based resin preferably includes a structural unit derived from a fluorene-based dihydroxy compound, a structural unit derived from an isosorbide-based dihydroxy compound, and a structural unit derived from an alicyclic dimethanol and/or a structural unit derived from di-, tri-, or polyethylene glycol, and more preferably includes a structural unit derived from a fluorene-based dihydroxy compound, a structural unit derived from an isosorbide-based dihydroxy compound, and a structural unit derived from di-, tri-, or polyethylene glycol. The polycarbonate-based resin may include a structural unit derived from any other dihydroxy compound as required. The Details of the polycarbonate-based resin that may be suitably used in the second λ/4 member and a method of forming the second λ/4 member are described in, for example, JP 2014-10291 A, JP 2014-26266 A, JP 2015-212816 A, JP 2015-212817 A, and JP 2015-212818 A, the descriptions of which are incorporated herein by reference.

The thickness of the second λ/4 member including the stretched film of the resin film is, for example, from 10 μm to 100 μm, preferably from 10 μm to 70 μm, more preferably from 20 μm to 60 μm.

The alignment fixed layer of the liquid crystal compound is such a layer that the liquid crystal compound is aligned in a predetermined direction in the layer, and its alignment state is fixed. The term "alignment fixed layer" is a concept encompassing an alignment cured layer obtained by curing a liquid crystal monomer as described later. In the second λ/4 member, the molecules of a rod-shaped liquid crystal compound are typically aligned under the state of being lined up in the slow axis direction of the second λ/4 member (homogeneous alignment). Examples of the rod-shaped liquid crystal compound include a liquid crystal polymer and a liquid crystal monomer. The liquid crystal compound is preferably polymerizable. When the liquid crystal compound is polymerizable, the alignment state of the liquid crystal compound can be fixed by aligning the liquid crystal compound and then polymerizing the compound.

The alignment fixed layer of the liquid crystal compound (liquid crystal alignment fixed layer) may be formed by:

subjecting the surface of a predetermined substrate to alignment treatment; applying an application liquid containing a liquid crystal compound to the surface; aligning the liquid crystal compound in a direction corresponding to the alignment treatment; and fixing the alignment state. Any appropriate alignment treatment may be adopted as the alignment treatment. Specific examples thereof include mechanical alignment treatment, physical alignment treatment, and chemical alignment treatment. Specific examples of the mechanical alignment treatment include rubbing treatment and stretching treatment. Specific examples of the physical alignment treatment include magnetic field alignment treatment and electric field alignment treatment. Specific examples of the chemical alignment treatment include an oblique deposition method and photoalignment treatment. Any appropriate conditions may be adopted as treatment conditions for the various alignment treatments in accordance with purposes.

The alignment of the liquid crystal compound is performed through treatment at a temperature at which the liquid crystal compound shows a liquid crystal phase depending on the kind of the liquid crystal compound. When the treatment at such temperature is performed, the liquid crystal compound adopts a liquid crystal state, and the liquid crystal compound is aligned in accordance with the alignment treatment direction of the surface of the substrate.

In one embodiment, the fixation of the alignment state is performed by cooling the liquid crystal compound aligned as described above. When the liquid crystal compound is polymerizable or cross-linkable, the fixation of the alignment state is performed by subjecting the liquid crystal compound aligned as described above to polymerization treatment or cross-linking treatment.

Any appropriate liquid crystal polymer and/or liquid crystal monomer is used as the liquid crystal compound. The liquid crystal polymers and the liquid crystal monomers may each be used alone or in combination thereof. Specific examples of the liquid crystal compound and a method of producing the liquid crystal alignment fixed layer are described in, for example, JP 2006-163343 A, JP 2006-178389 A, and WO 2018/123551 A1, the descriptions of which are incorporated herein by reference.

The thickness of the second λ/4 member including the liquid crystal alignment fixed layer is, for example, from 1 $\mu$m to 10 $\mu$m, preferably from 1 $\mu$m to 8 $\mu$m, more preferably from 1 $\mu$m to 6 $\mu$m, still more preferably from 1 $\mu$m to 4 $\mu$m.

The thickness direction retardation Rth(550) of the positive C-plate is preferably from -50 nm to -300 nm, more preferably from -70 nm to -250 nm, still more preferably from - 90 nm to -200 nm, particularly preferably from -100 nm to -180 nm. The equation "nx=ny" as used herein encompasses not only a case in which the nx and the ny are strictly equal to each other but also a case in which the nx and the ny are substantially equal to each other. The in-plane retardation Re(550) of the positive C-plate is, for example, less than 10 nm.

The positive C-plate may be formed from any appropriate material. However, the positive C-plate preferably includes a film containing a liquid crystal material fixed in homeotropic alignment. The liquid crystal material (liquid crystal compound) that can be homeotropically aligned may be a liquid crystal monomer or a liquid crystal polymer. Such liquid crystal compound and a method of forming the positive C-plate are specifically, for example, a liquid crystal compound and a method of forming the retardation layer described in paragraphs [0020] to [0028] of JP 2002-333642 A. In this case, the thickness of the positive C-plate is preferably from 0.5 $\mu$m to 5 $\mu$m.

The first protective member may be typically a laminate film including a substrate and a surface-treated layer. The first protective member including the surface-treated layer may be arranged so that the surface-treated layer may be positioned on the front side. Specifically, the surface-treated layer may be positioned on the outermost surface of the first laminate portion.

The first protective member has a maximum value for a 5° specular reflectance spectrum in the wavelength range of from 420 nm to 680 nm of 0% or more and 1.2% or less, preferably 1.0% or less, more preferably 0.8% or less. When the protective member having such reflection characteristic is positioned on the outermost surface of the laminate portion, viewability can be remarkably improved. Specifically, when the protective member that is brought into contact with the space formed between the first lens portion **16** and the second lens portion **24** satisfies the above-mentioned reflection characteristic, loss of light due to reflection at an interface between air and the protective member can be extremely satisfactorily suppressed. In the display system **2** in which a large number of members are used, the amount of light to be required is large, and hence a suppressing effect on the loss of light can be significantly obtained. As described above, in the display system **2** illustrated in FIG. **1,** the light may pass the member arranged between the half mirror **18** and the reflection-type polarizing member **14** three times, and hence the suppressing effect on the loss of light can be significantly obtained. In addition, when the protective member satisfies the above-mentioned reflection characteristic, a residual image (ghost) derived from reflection can be suppressed from being viewed.

As described above, when the amount of light to be used is large, management of hue may be important. For example, a balance of reflectance in a visible light region may be important. The first protective member has a 5° specular reflectance at a wavelength of 450 nm of, for example, 0.01% or more and 0.4% or less, preferably 0.3% or less, more preferably 0.2% or less, still more preferably 0.1% or less. The first protective member has a 5° specular reflectance at a wavelength of 600 nm of, for example, 0.01% or more and 0.4% or less, preferably 0.3% or less, more preferably 0.2% or less, still more preferably 0.1% or less.

The 5° specular reflectance spectrum in the wavelength range of from 420 nm to 680 nm of the first protective member may include local minimum values in the wavelength range of from 450 nm to 480 nm and the wavelength range of from 600 nm to 630 nm. For example, a ratio of an average Ave(450-480 nm) of 5° specular reflectances in the wavelength range of from 450 nm to 480 nm with respect to an average Ave(530-560 nm) of 5° specular reflectances in the wavelength range of from 530 nm to 560 nm is preferably 0.10 or more and 0.90 or less, more preferably 0.80 or less. In addition, a ratio of an average Ave(600-630 nm) of 5° specular reflectances in the wavelength range of from 600 nm to 630 nm with respect to the average Ave(530-560 nm) of the 5° specular reflectances in the wavelength range of from 530 nm to 560 nm is preferably 0.10 or more and 0.50 or less, more preferably 0.40 or less. The average of the 5° specular reflectances may be determined by, for example, sampling seven measurement values at intervals of 5 nm in the respective wavelength ranges, and dividing the total of these values by the number of the sampled wavelengths (seven).

A surface smoothness of the first protective member is preferably 0.5 arcmin or less, more preferably 0.4 arcmin or less. When the protective member that satisfies such smoothness is used, occurrence of diffused light is suppressed, and hence the image can be suppressed from becoming unclear. Substantially, the surface smoothness of the first protective member is, for example, 0.1 arcmin or more. The thickness of the first protective member is preferably from 10 $\mu$m to 80 $\mu$m, more preferably from 15 $\mu$m to 60 $\mu$m, still more preferably from 20 $\mu$m to 45 $\mu$m.

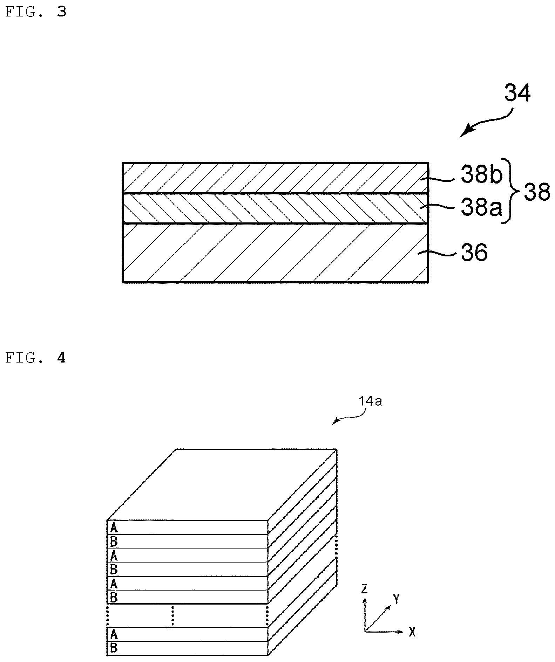

FIG. 3 is a schematic sectional view for illustrating the schematic configuration of a laminate film according to one embodiment of the present invention. A laminate film **34** includes: a substrate **36;** and a surface-treated layer **38** arranged above the substrate **36**. The thickness of the substrate **36** is preferably from 5 $\mu$m to 80 $\mu$m, more preferably from 10 $\mu$m to 50 $\mu$m, still more preferably from 15 $\mu$m to 40 $\mu$m. A surface smoothness of the substrate **36** is preferably 0.7 arcmin or less, more preferably 0.6 arcmin or less, still more preferably 0.5 arcmin or less. The surface smoothness may be measured by focusing irradiation light on a surface of an object.

The substrate **36** may include any appropriate film. Examples of a material serving as a main component of the film for forming the substrate **36** include: a cellulose-based resin such as triacetylcellulose (TAC); a polyester-based resin; a polyvinyl alcohol-based resin; a polycarbonate-based resin; a polyamide-based resin; a polyimide-based resin; a polyethersulfone-based resin; a polysulfone-based resin; a polystyrene-based resin; a cycloolefin-based resin such as polynorbornene; a polyolefin-based resin; a (meth)acrylic resin; and an acetate-based resin. The term "(meth) acrylic" as used herein refers to acrylic and/or methacrylic. In one embodiment, the substrate **36** preferably includes a (meth)acrylic resin. When the (meth)acrylic resin is adopted, the above-mentioned surface smoothness can be satisfactorily satisfied. Specifically, when the (meth)acrylic resin is adopted, a substrate having an excellent surface smoothness can be obtained by film forming through extrusion molding.

The thickness of the surface-treated layer **38** is preferably from 0.5 $\mu$m to 10 $\mu$m, more preferably from 1 $\mu$m to 7 $\mu$m, still more preferably from 2 $\mu$m to 5 $\mu$m. The surface-treated layer **38** includes, for example, a hard coat layer **38a** and a functional layer **38b** having an antireflection function.

The hard coat layer **38a** is typically formed by applying a material for forming a hard coat layer to the substrate 36, and curing the applied layer. The material for forming a hard coat layer typically contains a curable compound serving as a layer-forming component. A curing mechanism of the curable compound is, for example, a thermosetting type or a photocurable type. Examples of the curable compound include a monomer, an oligomer, and a prepolymer. A polyfunctional monomer or oligomer is preferably used as the curable compound. Examples of the polyfunctional monomer or oligomer include a monomer or oligomer having two or more (meth)acryloyl groups, urethane (meth)acrylate or an oligomer of urethane (meth)acrylate, an epoxy-based monomer or oligomer, and a silicone-based monomer or oligomer.

The thickness of the hard coat layer **38a** is preferably from 0.5 $\mu$m to 10 $\mu$m, more preferably from 1 $\mu$m to 7 $\mu$m, still more preferably from 2 $\mu$m to 5 $\mu$m.

The functional layer **38b** preferably has a laminated structure including a high-refractive index layer and a low-refractive index layer. The functional layer **38b** preferably includes the high-refractive index layer and the low-refractive index layer in this order from a substrate **36** side. When the functional layer **38b** has such laminated structure, the above-mentioned reflection characteristic can be satisfactorily satisfied.

For example, the high-refractive index layer may include a high-refractive index resin (e.g., a refractive index measured under the condition of a wavelength of 550 nm is 1.55 or more). In this case, the high-refractive index layer may be typically an applied layer. In addition, for example, the high-refractive index layer may include an inorganic film. In this case, the high-refractive index layer may be typically formed by physical vapor deposition such as vacuum deposition or sputtering, or chemical vapor deposition.

The thickness of the high-refractive index layer is preferably from 10 nm to 200 nm, more preferably from 20 nm to 150 nm.

The thickness of the low-refractive index layer is preferably from 10 nm to 200 nm, more preferably from 20 nm to 150 nm.

The low-refractive index layer (antireflection layer) may be obtained by, for example, curing a coating film obtained by applying an application liquid for forming a low-refractive index layer (antireflection layer), and drying the liquid. The application liquid for forming an antireflection layer may contain, for example, a resin component (curable compound), a fluorine-containing additive, hollow particles, solid particles, and a solvent, and may be obtained by, for example, mixing these components.

A curing mechanism of the resin component (curable compound) in the application liquid for forming an antireflection layer is, for example, a thermosetting type or a photocurable type. A curable compound having at least one of an acrylate group or a methacrylate group is used as the resin component, and examples thereof include oligomers and prepolymers of acrylates or methacrylates of a silicone resin, a polyester resin, a polyether resin, an epoxy resin, a urethane resin, an alkyd resin, a spiroacetal resin, a polybutadiene resin, a polythiol polyene resin, and a polyfunctional compound such as a polyhydric alcohol. Those components may be used alone or in combination thereof.

For example, a reactive diluent having at least one of an acrylate group or a methacrylate group may also be used as the resin component. For example, a reactive diluent described in JP 2008-88309 A may be used as the reactive diluent, and examples thereof include a monofunctional acrylate, a monofunctional methacrylate, a polyfunctional acrylate, and a polyfunctional methacrylate. A tri- or higher functional acrylate and a tri- or higher functional methacrylate are each preferably used as the reactive diluent from the viewpoint of obtaining excellent hardness. Further examples of the reactive diluent include butanediol glycerol ether diacrylate, an acrylate of isocyanuric acid, and a methacrylate of isocyanuric acid. Those components may be used alone or in combination thereof. For curing the resin component, a curing agent may be used, for example. A known polymerization initiator (e.g., thermal polymerization initiator or photopolymerization initiator) may be used as the curing agent.

The fluorine-containing additive may be, for example, an organic compound containing fluorine or an inorganic compound containing fluorine. Examples of the organic compound containing fluorine include a fluorine-containing antifouling coating agent, a fluorine-containing acrylic compound, or a fluorine-silicon-containing acrylic compound. A commercially available product may be used as the organic compound containing fluorine. Specific examples of the commercially available product include: "KY-1203" (product name) manufactured by Shin-Etsu Chemical Co., Ltd.; and "MEGAFACE" (product name) manufactured by DIC Corporation. The content of the fluorine-containing additive may be, for example, 0.05 part by weight or more, 0.1 part by weight or more, 0.15 part by weight or more, 0.20 part by weight or more, or 0.25 part by weight or more, and may be 20 parts by weight or less, 15 parts by weight or less, 10 parts by weight or less, 5 parts by weight or less, or 3 parts by weight or less with respect to 100 parts by weight of the resin component.

For example, silica particles, acrylic particles, and acrylic-styrene copolymer particles are used as the hollow particles. Commercially available products (e.g., "THRULYA 5320" and "THRULYA 4320" (product names) manufactured by JGC Catalysts and Chemicals Ltd.) may be used as hollow silica particles. The weight-average particle diameter of the hollow particles may be, for example, 30 nm or more, 40 nm or more, 50 nm or more, 60 nm or more, or 70 nm or more, and may be 150 nm or less, 140 nm or less, 130 nm or less, 120 nm or less, or 110 nm or less. The shape of each of the hollow particles is not particularly limited, but is preferably a substantially spherical shape. Specifically, the aspect ratio of each of the hollow particles is preferably 1.5 or less. The content of the hollow particles may be, for example, 30 parts by weight or more, 50 parts by weight or more, 70 parts by weight or more, 90 parts by weight or more, or 100 parts by weight or more, and may be 300 parts by weight or less, 270 parts by weight or less, 250 parts by weight or less, 200 parts by weight or less, or 180 parts by weight or less with respect to 100 parts by weight of the resin component.

For example, silica particles, zirconia particles, and titania particles are used as the solid particles. Commercially available products (e.g., "MEK-2140Z-AC", "MIBK-ST", and "IPA-ST" (product names) manufactured by Nissan Chemical Industries, Ltd.) may be used as solid silica particles. The weight-average particle diameter of the solid particles may be, for example, 5 nm or more, 10 nm or more, 15 nm or more, 20 nm or more, or 25 nm or more, and may be 330 nm or less, 250 nm or less, 200 nm or less, 150 nm or less, or 100 nm or less. The shape of each of the solid particles is not particularly limited, but is preferably a substantially spherical shape. Specifically, the aspect ratio of each of the solid particles is preferably 1.5 or less. The content of the solid particles may be, for example, 5 parts by weight or more, 10 parts by weight or more, 15 parts by weight or more, 20 parts by weight or more, or 25 parts by weight or more, and may be 150 parts by weight or less, 120 parts by weight or less, 100 parts by weight or less, or 80 parts by weight or less with respect to 100 parts by weight of the resin component.

Any appropriate solvent may be used as the solvent. Examples of the solvent include: alcohols, such as methanol, ethanol, isopropyl alcohol, butanol, tertiary butyl alcohol (TBA), and 2-methoxyethanol; ketones, such as acetone, methyl ethyl ketone, methyl isobutyl ketone (MIBK), and cyclopentanone; esters, such as methyl acetate, ethyl acetate, butyl acetate, and propylene glycol monomethyl ether acetate (PMA); ethers, such as diisopropyl ether and propylene glycol monomethyl ether; glycols, such as ethylene glycol and propylene glycol; cellosolves, such as ethyl cellosolve and butyl cellosolve; aliphatic hydrocarbons, such as hexane, heptane, and octane; and aromatic hydrocarbons, such as benzene, toluene, and xylene. Those solvents may be used alone or in combination thereof. For example, the content of the solvent may be set so that the ratio of the weight of the solid content with respect to the total weight of the application liquid for forming an antireflection layer becomes, for example, 0.1 wt% or more, 0.3 wt% or more, 0.5 wt% or more, 1.0 wt% or more, or 1.5 wt% or more, and may be set so that the ratio becomes 20 wt% or less, 15 wt% or less, 10 wt% or less, 5 wt% or less, or 3 wt% or less.

A known application method, such as fountain coating, die coating, spin coating, spray coating, gravure coating, roll coating, or bar coating, may be used as a method of applying the application liquid for forming an antireflection layer.

The drying temperature of the coating film is, for example, from 30°C to 200°C, and the drying time thereof is, for example, from 30 seconds to 90 seconds. The curing of the coating film may be performed by, for example, heating or photoirradiation (typically, UV irradiation). For example, a high-pressure mercury lamp is used as a light source of the photoirradiation. The irradiation amount of the UV irradiation is preferably from 50 mJ/cm$^2$ to 500 mJ/cm$^2$ as an integrated exposure at a UV wavelength of 365 nm.

The second laminate portion **200** includes: the reflection-type polarizing member **14**; and an adhesion layer (e.g., a pressure-sensitive adhesive layer) arranged between the reflection-type polarizing member **14** and the second lens portion **24**. The second laminate portion **200** further includes an absorption-type polarizing member **28** arranged between the reflection-type polarizing member **14** and the second lens portion **24** from the viewpoint of, for example, improving the viewability. The absorption-type polarizing member **28** is laminated on the front side of the reflection-type polarizing member **14** via an adhesion layer (e.g., a pressure-sensitive adhesive layer) **44**. The reflection axis of the reflection-type polarizing member **14** and the absorption axis of the absorption-type polarizing member **28** may be arranged substantially parallel to each other, and the transmission axis of the reflection-type polarizing member **14** and the transmission axis of the absorption-type polarizing member **28** may be arranged substantially parallel to each other. The reflection-type polarizing member **14** and the absorption-type polarizing member **28** are fixed to each other through lamination of the members via the adhesion layer, and hence a shift in the axial arrangement of the reflection axis of the member **14** and the absorption axis of the member **28** (the transmission axis of the member **14** and the transmission axis of the member **28**) can be prevented. In addition, an adverse effect due to an air layer that may be formed between the reflection-type polarizing member **14** and the absorption-type polarizing member **28** can be suppressed.

The second laminate portion **200** further includes a second protective member **32** arranged on the back side of the reflection-type polarizing member **14**. The second protective member **32** is laminated on the reflection-type polarizing member **14** via an adhesion layer (e.g., a pressure-sensitive adhesive layer) **43**. The second protective member **32** may be positioned on the outermost surface of the second laminate portion **200**. The first protective member **31** and the second protective member **32** are arranged to face each other through a space. The second protective member may be typically a laminate film including a substrate and a surface-treated layer as with the first protective member. In this case, the surface-treated layer may be positioned on the outermost surface of the second laminate portion. For the details of the second protective member, the same descriptions as those in the first protective member may be applied. Specifically, for the reflection characteristic of the second protective member and effects thereof, and the smoothness, configuration, thickness, and formation material thereof, the same descriptions as those in the first protective member may be applied.

In the example illustrated in FIG. 2, the second laminate portion **200** further includes a third retardation member **30** arranged between the absorption-type polarizing member **28** and the second lens portion **24**. The third retardation member **30** is laminated on the absorption-type polarizing member **28** via an adhesion layer (e.g., a pressure-sensitive adhesive layer) **45**. In addition, the third retardation member **30** is laminated on the second lens portion **24** via an adhesion layer (e.g., a pressure-sensitive adhesive layer) **46**, and the second laminate portion **200** is arranged integrally with the second lens portion **24**. The third retardation member **30** includes, for example, a third λ/4 member. An angle formed by the absorption axis of the absorption-type polarizing member **28** and the slow axis of the third λ/4 member in the third retardation member **30** is, for example, from 40° to 50°, may be from 42° to 48°, or may be about 45°. When such member is arranged, for example, the reflection of ambient light from a second lens portion **24** side can be prevented. When the third retardation member is free of any member other than the third λ/4 member, the third retardation member may correspond to the third λ/4 member.

The above-mentioned reflection-type polarizing member can transmit polarized light (typically, linearly polarized light) parallel to its transmission axis while maintaining the polarization state of the light, and can reflect light in any other polarization state. The reflection-type polarizing member typically includes a film having a multilayer structure (sometimes referred to as "reflection-type polarizing film"). In this case, the thickness of the reflection-type polarizing member is, for example, from 10 μm to 150 μm, preferably from 20 μm to 100 μm, more preferably from 30 μm to 60 μm.

FIG. **4** is a schematic perspective view for illustrating an example of the multilayer structure in the reflection-type polarizing film. A multilayer structure **14a** alternately includes a layer A having birefringence and a layer B substantially free of birefringence. The total number of the layers for forming the multilayer structure may be from 50 to 1,000. For example, the refractive index nx of the A layer in an x-axis direction is larger than the refractive index ny thereof in a y-axis direction, the refractive index nx of the B layer in the x-axis direction and the refractive index ny thereof in the y-axis direction are substantially identical to each other, and a difference in refractive index between the A layer and the B layer is large in the x-axis direction, and is substantially zero in the y-axis direction. As a result, the x-axis direction may serve as a reflection axis, and the y-axis direction may serve as a transmission axis. The difference in refractive index between the A layer and the B layer in the x-axis direction is preferably from 0.2 to 0.3.

The above-mentioned A layer typically includes a material that expresses birefringence by being stretched. Examples of such material include a naphthalene dicarboxylic acid polyester (e.g., polyethylene naphthalate), polycarbonate, and an acrylic resin (e.g., polymethyl methacrylate). The above-mentioned B layer typically includes a material that is substantially free from expressing birefringence even when stretched. Such material is, for example, a copolyester of naphthalene dicarboxylic acid and terephthalic acid. The above-mentioned multilayer structure may be formed by combining coextrusion and stretching. For example, the material for forming the A layer and the material for forming the B layer are extruded, and are then multilayered (with, for example, a multiplier). Next, the resultant multilayer laminate is stretched. The x-axis direction in the illustrated example may correspond to the stretching direction.

A commercial product of the reflection-type polarizing film is, for example, a product available under the product name "DBEF" or "APF" from 3M Company, or a product available under the product name "APCF" from Nitto Denko Corporation.

The cross transmittance (Tc) of the reflection-type polarizing member (reflection-type polarizing film) may be, for example, from 0.01% to 3%. The single layer transmittance (Ts) of the reflection-type polarizing member (reflection-type polarizing film) is, for example, from 43% to 49%, preferably from 45% to 47%. The polarization degree (P) of the reflection-type polarizing member (reflection-type polarizing film) may be, for example, from 92% to 99.99%.

The cross transmittance, the single layer transmittance, and the polarization degree described above may each be measured with, for example, a UV-visible spectrophotometer. The polarization degree P may be determined as follows: the single layer transmittance Ts, the parallel transmittance Tp, and the cross transmittance Tc are measured with the UV-visible spectrophotometer; and the degree is determined from the Tp and Tc thus obtained by using the following equation. The Ts, the Tp, and the Tc are each a Y value measured with the two-degree field of view (C light source) of JIS Z 8701 and subjected to visibility correction.

$$\mathtt{Polarization\ degree\ P\ (\%)=\{(Tp\!-\!Tc)/(Tp\!+\!Tc)\}^{1/2}\!\times\!100}$$

The above-mentioned absorption-type polarizing member may typically include a resin film containing a dichroic substance (sometimes referred to as "absorption-type polarizer"). The thickness of the absorption-type polarizer is, for example, 1 $\mu$m or more and 20 $\mu$m or less, and may be 2 $\mu$m or more and 15 $\mu$m or less, may be 12 $\mu$m or less, may be 10 $\mu$m or less, may be 8 $\mu$m or less, or may be 5 $\mu$m or less.

The above-mentioned absorption-type polarizer may be produced from a single-layer resin film, or may be produced by using a laminate of two or more layers.

When the absorption-type polarizer is produced from the single-layer resin film, the absorption-type polarizer may be obtained by, for example, subjecting a hydrophilic polymer film, such as a polyvinyl alcohol (PVA)-based film, a partially formalized PVA-based film, or an ethylene-vinyl acetate copolymer-based partially saponified film, to dyeing treatment with a dichroic substance, such as iodine or a dichroic dye, stretching treatment, or the like. Of such polarizers, an absorption-type polarizer obtained by dyeing a PVA-based film with iodine and uniaxially stretching the dyed film is preferred.

The above-mentioned dyeing with iodine is performed by, for example, immersing the PVA-based film in an aqueous solution of iodine. The stretching ratio of the above-mentioned uniaxial stretching is preferably from 3 times to 7 times. The stretching may be performed after the dyeing treatment, or may be performed while the dyeing is performed. Alternatively, the dyeing may be performed after the stretching. The PVA-based film is subjected to swelling treatment, cross-linking treatment, washing treatment, drying treatment, or the like as required.

When the absorption-type polarizer is produced by using the above-mentioned laminate of two or more layers, the laminate is, for example, a laminate of a resin substrate and a PVA-based resin layer (PVA-based resin film) laminated on the resin substrate or a laminate of a resin substrate and a PVA-based resin layer formed on the resin substrate through application. The absorption-type polarizer obtained by using the laminate of the resin substrate and the PVA-based resin layer formed on the resin substrate through application may be produced, for example, by: applying a PVA-based resin solution to the resin substrate; drying the solution to form the PVA-based resin layer on the resin substrate, to thereby provide the laminate of the resin substrate and the PVA-based resin layer; and stretching and dyeing the laminate to turn the PVA-based resin layer into the absorption-type polarizer. In this embodiment, a polyvinyl alcohol-based resin layer containing a halide and a polyvinyl alcohol-based resin is preferably formed on one side of the resin substrate. The stretching typically includes stretching the laminate under a state in which the laminate is immersed in an aqueous solution of boric acid. Further, the stretching may further include in-air stretching of the laminate at high temperature (e.g., 95°C or more) before the stretching in the aqueous solution of boric acid as required. In addition, in this embodiment, the laminate is preferably subjected to drying shrinkage treatment, which includes heating the laminate, while conveying the laminate in its lengthwise direction, to shrink the laminate by 2% or more in its widthwise direction. The production method of this embodiment typically includes subjecting the laminate to in-air auxiliary stretching treatment, dyeing treatment, underwater stretching treatment, and drying shrinkage treatment in the stated order. When the auxiliary stretching is introduced, even in the case where PVA is applied onto a thermoplastic resin, the crystallinity of PVA can be improved, and hence high optical characteristics can be achieved. In addition, when the alignment property of PVA is improved in advance simultaneously with the crystallinity improvement, problems, such as a reduction in alignment property of PVA and the dissolution thereof, can be prevented at the time of the immersion of the laminate in water in the subsequent dyeing step or stretching step, and hence high optical characteristics can be achieved. Further, in the case where the PVA-based resin layer is immersed in a liquid, the disturbance of the alignment of the molecules of polyvinyl alcohol and reductions in alignment properties thereof can be suppressed as compared to those in the case where the PVA-based resin layer is free of any halide. Thus, the optical characteristics of the absorption-type polarizer to be obtained through treatment steps performed by immersing the laminate in a liquid, such as the dyeing treatment and the underwater stretching treatment, can be improved. Further, the optical characteristics can be improved by shrinking the laminate in its widthwise direction through the drying shrinkage treatment. The resultant laminate of the resin substrate and the absorption-type polarizer may be used as it is (that is, the resin substrate may be used as a protective layer for the absorption-type polarizer), or may be used by laminating any appropriate protective layer in accordance with purposes on the peeled surface on which the resin substrate has been peeled from the laminate of the resin substrate and the absorption-type polarizer, or on a surface on the side opposite to the peeled surface. The details of such method of producing the absorption-type polarizer are described in, for example, JP 2012-73580 A and JP 6470455 B1, the descriptions of which are incorporated herein by reference in their entirety.

The cross transmittance (Tc) of the absorption-type polarizing member (absorption-type polarizer) is preferably 0.5% or less, more preferably 0.1% or less, still more preferably 0.05% or less. The single layer transmittance (Ts) of the absorption-type polarizing member (absorption-type polarizer) is, for example, from 41.0% to 45.0%, preferably 42.0% or more. The polarization degree (P) of the absorption-type polarizing member (absorption-type polarizer) is, for example, from 99.0% to 99.997%, preferably 99.9% or more.

The in-plane retardation Re(550) of the third $\lambda/4$ member is, for example, from 100 nm to 190 nm, and may be from 110 nm to 180 nm, may be from 130 nm to 160 nm, or may be from 135 nm to 155 nm. The third $\lambda/4$ member preferably shows such a reverse wavelength dispersion characteristic that its retardation value increases with an increase in wavelength of measurement light. The ratio "Re(450)/Re(550)" of the third $\lambda/4$ member is, for example, 0.75 or more and less than 1, and may be 0.8 or more and 0.95 or less. The refractive index characteristic of the third $\lambda/4$ member preferably shows the relationship of nx>ny≥nz. The Nz coefficient of the third $\lambda/4$ member is preferably from 0.9 to 3, more preferably from 0.9 to 2.5, still more preferably from 0.9 to 1.5, particularly preferably from 0.9 to 1.3.

The third $\lambda/4$ member is formed from any appropriate material that may satisfy the above-mentioned characteristics. The third $\lambda/4$ member may be, for example, a stretched film of a resin film or an alignment fixed layer of a liquid crystal compound. The same description as that of the above-mentioned second $\lambda/4$ member may be applied to the third $\lambda/4$ member including the stretched film of the resin film or the alignment fixed layer of the liquid crystal compound. The second $\lambda/4$ member and the third $\lambda/4$ member may be members having the same configuration (e.g., a formation material, a thickness, or an optical characteristic), or may be members having different configurations.

Examples

The present invention is specifically described below by way of Examples. However, the present invention is not limited to these Examples. A thickness and a surface smoothness are values measured by the following measurement methods. In addition, the terms "part(s)" and "%" are by weight unless otherwise stated.

<Thickness>

A thickness of 10 μm or less was measured with a scanning electron microscope (manufactured by JEOL Ltd., product name: "JSM-7100F"). A thickness of more than 10 μm was measured with a digital micrometer (manufactured by Anritsu Corporation, product name: "KC-351C").

<Surface Smoothness>

A surface smoothness was measured with a scanning white-light interferometer (manufactured by Zygo Corporation, product name: "NewView 9000"). Specifically, a measurement sample was placed on a measurement table with a vibration isolation table to generate interference fringes with single white LED lighting. The sample was scanned with an interference objective lens (magnification: 1.4) having a reference surface in a Z-direction (thickness direction). Thus, the smoothness (surface smoothness) of the measurement object on its outermost surface in the range of a field of view of 12.4 mm□ was selectively acquired. An acrylic pressure-sensitive adhesive layer with little unevenness, the acrylic pressure-sensitive adhesive layer having a thickness of 5 μm, was formed on MICRO SLIDE GLASS (manufactured by Matsunami Glass Ind., Ltd., product name: "S200200"), and a film serving as a measurement object was laminated on a pressure-sensitive adhesive surface thereof so that foreign matter, an air bubble, or a deformation streak did not enter, followed by measurement of the smoothness of a surface on a side opposite to the pressure-sensitive adhesive layer.

With regard to an analysis, a value obtained by doubling an index of an angle "Slope magnitude RMS" (corresponding to 2σ) was defined as a surface smoothness (unit: arcmin).

[Example 1]

(Preparation of Material for forming Hard Coat Layer)

50 Parts of a urethane acrylic oligomer (manufactured by Shin-Nakamura Chemical Co., Ltd., "NK Oligo UA-53H"), 30 parts of a polyfunctional acrylate containing pentaerythritol triacrylate as a main component (manufactured by Osaka Organic Chemical Industry Ltd., product name: "Viscoat #300"), 20 parts of 4-hydroxybutyl acrylate (manufactured by Osaka Organic Chemical Industry Ltd.), 1 part of a leveling agent (manufactured by DIC Corporation, "GRANDIC PC4100"), and 3 parts of a photopolymerization initiator (manufactured by Ciba Japan K.K., "IRGACURE 907") were mixed. The mixture was diluted with methyl isobutyl ketone so as to have a solid content concentration of 50%. Thus, a material for forming a hard coat layer was prepared.

(Preparation of Application Liquid for forming High-refractive Index Layer)

100 Parts by weight of a polyfunctional acrylate (manufactured by Arakawa Chemical Industries, Ltd., product name: "OPSTAR KZ6728", solid content: 20 wt%), 3 parts by weight of a leveling agent (manufactured by DIC Corporation, "GRANDIC PC4100"), and 3 parts by weight of a photopolymerization initiator (manufactured by BASF SE, product name: "OMNIRAD 907", solid content: 100 wt%) were mixed. Butyl acetate was used as a diluting solvent to adjust the solid content of the mixture to 12 wt%, followed by stirring. Thus, an application liquid for forming a high-refractive index layer was prepared.

(Preparation of Application Liquid A for forming Low-refractive Index Layer)

100 Parts by weight of a polyfunctional acrylate containing pentaerythritol triacrylate as a main component (manufactured by Osaka Organic Chemical Industry Ltd., product name: "Viscoat #300", solid content: 100 wt%), 150 parts by weight of hollow nanosilica particles (manufactured by JGC Catalysts and Chemicals Ltd., product name: "THRULYA 5320", solid content: 20 wt%, weight-average particle diameter: 75 nm), 50 parts by weight of solid nanosilica particles (manufactured by Nissan Chemical Industries, Ltd., product name: "MEK-2140Z-AC", solid content: 30 wt%, weight-average particle diameter: 10 nm), 12 parts by weight of a fluorine-containing additive (manufactured by Shin-Etsu Chemical Co., Ltd., product name: "KY-1203", solid content: 20 wt%), and 3 parts by weight of a photopolymerization initiator (manufactured by BASF SE, product name: "OMNIRAD 907", solid content: 100 wt%) were mixed. A mixed solvent obtained by mixing tertiary butyl alcohol (TBA), methyl isobutyl ketone (MIBK), and propylene glycol monomethyl ether acetate (PMA) at a weight ratio of 60:25:15 was added as a diluting solvent to the mixture so that the total solid content became 4 wt%, and the resultant was then stirred. Thus, an application liquid for forming a low-refractive index layer was prepared.

The above-mentioned material for forming a hard coat layer was applied to an acrylic film having a lactone ring structure (thickness: 40 $\mu$m, surface smoothness: 0.45 arcmin). The resultant was heated at 90°C for 1 minute. The applied layer after the heating was irradiated with UV light at an integrated light quantity of 300 mJ/cm$^2$ with a high-pressure mercury lamp so that the applied layer was cured. Thus, an acrylic film (thickness: 44 $\mu$m, surface smoothness on the hard coat layer side: 0.4 arcmin) having a hard coat layer having a thickness of 4 $\mu$m formed thereon was produced.

Next, the above-mentioned application liquid for forming a high-refractive index layer was applied onto the hard coat layer with a wire bar. The applied application liquid was dried by heating at 80°C for 1 minute to form a coating film. The coating film after the drying was irradiated with UV light at an integrated light quantity of 300 mJ/cm$^2$ with a high-pressure mercury lamp so that the coating film was cured. Thus, a high-refractive index layer having a thickness of 140 nm was formed.

Subsequently, the above-mentioned application liquid for forming a low-refractive index layer was applied onto the high-refractive index layer with a wire bar. The applied application liquid was dried by heating at 80°C for 1 minute to form a coating film. The coating film after the drying was irradiated with UV light at an integrated light quantity of 300 mJ/cm$^2$ with a high-pressure mercury lamp so that the coating film was cured. Thus, a low-refractive index layer having a thickness of 105 nm was formed.

Thus, a laminate film having a thickness of 44 $\mu$m and a surface smoothness of 0.4 arcmin was obtained.

[Comparative Example 1]

A laminate film having a thickness of 44 $\mu$m and a surface smoothness of 0.4 arcmin was obtained in the same manner as in Example 1 except that: the high-refractive index layer was not formed; and the following application liquid B was used as the application liquid for forming a low-refractive index layer to form a low-refractive index layer having a thickness of 100 nm.

(Preparation of Application Liquid B for forming Low-refractive Index Layer)

100 Parts by weight of a polyfunctional acrylate containing pentaerythritol triacrylate as a main component (manufactured by Osaka Organic Chemical Industry Ltd., product name: "Viscoat #300", solid content: 100 wt%), 100 parts by weight of hollow nanosilica particles (manufactured by JGC Catalysts and Chemicals Ltd., product name: "THRULYA 5320", solid content: 20 wt%, weight-average particle diameter: 75 nm), 12 parts by weight of a fluorine-containing additive (manufactured by Shin-Etsu Chemical Co., Ltd., product name: "KY-1203", solid content: 20 wt%), and 3 parts by weight of a photopolymerization initiator (manufactured by BASF SE, product name: "OMNIRAD 907", solid content: 100 wt%) were mixed. A mixed solvent obtained by mixing tertiary butyl alcohol (TBA), methyl isobutyl ketone (MIBK), and propylene glycol monomethyl ether acetate (PMA) at a weight ratio of 60:25:15 was added as a diluting solvent to the mixture so that the total solid content became 4 wt%, and the resultant was then stirred. Thus, an application liquid B for forming an low-refractive index layer was prepared.

[Comparative Example 2]

A laminate film having a thickness of 44 μm and a surface smoothness of 0.4 arcmin was obtained in the same manner as in Example 1 except that the high-refractive index layer and the low-refractive index layer were not formed.

<Evaluation>

(1) 5° Specular Reflectance

A test piece having a size of 50 mm×50 mm was cut out from the laminate film of each of Example 1, Comparative Example 1, and Comparative Example 2, and the test piece was bonded to a black acrylic plate with a pressure-sensitive adhesive to provide a measurement sample. The specular reflectance spectrum of the sample was measured with a spectrophotometer (manufactured by Hitachi High-Technologies Corporation, product name: "U-4100") as a measurement apparatus. A measurement wavelength was set to fall within the range of from 420 nm to 680 nm, and an incident angle of light with respect to the measurement sample was set to 5°.

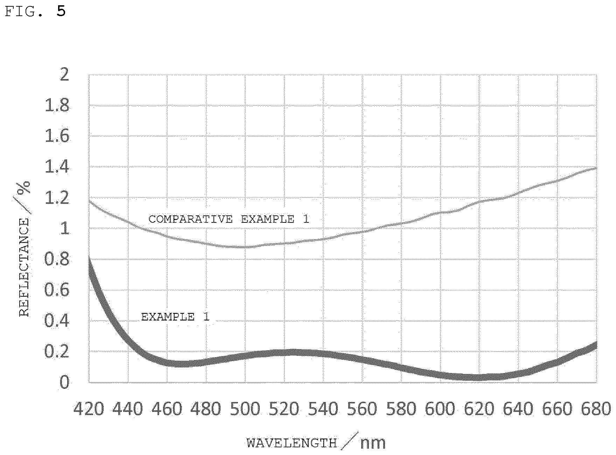

The 5° specular reflectance spectrum of the laminate film of each of Example 1 and Comparative Example 1 is shown in FIG. **5.** As shown in FIG. **5,** the maximum value for the 5° specular reflectance spectrum of the laminate film of Example 1 in the wavelength range of from 420 nm to 680 nm was 0.75%. In addition, the 5° specular reflectance thereof at a wavelength of 450 nm was 0.17%, and the 5° specular reflectance thereof at a wavelength of 600 nm was 0.05%. The results of Comparative Example 1 and Comparative Example 2 are as shown below.

Table 1

| Reflectance | Example 1 | Comparative Example 1 | Comparative Example 2 |
|---|---|---|---|
| Maximum value | 0.75 | 1.39 | 4.5 |
| 450 nm | 0.17 | 0.99 | 4.5 |
| 600 nm | 0.05 | 1.10 | 4.3 |

(2) Appearance 1

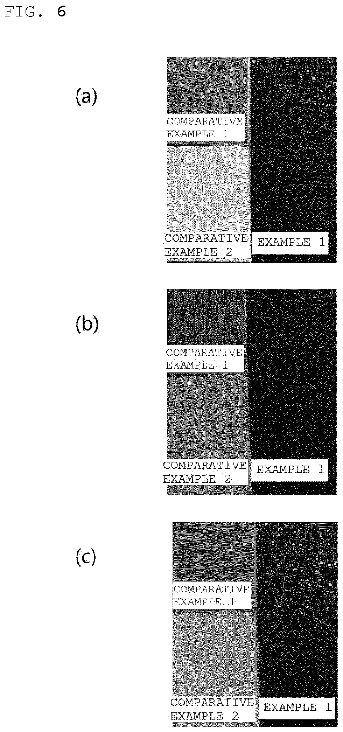

The laminate film of each of Example 1, Comparative Example 1, and Comparative Example 2 was bonded to a black acrylic plate with a pressure-sensitive adhesive to provide a measurement plate. The appearance (reflection appearance) of the measurement plate was visually observed when, in a dark room, light was applied at a light control volume of 1 toward the measurement plate from a surface emitting unit (manufactured by AI Tec System Co., Ltd., LED Lighting Box "LLBK1") arranged at a position distant therefrom by 18 cm so as to face the measurement plate. The reflection appearance is shown in each of FIG. **6(a),** FIG. **6(b),** and FIG. **6(c).** Specifically, FIG. **6(a)** shows a result when light representing white was applied, FIG. **6(b)** shows a result when blue light (wavelength: 450 nm±30 nm) was applied, and FIG. **6(c)** shows a result when red light (wavelength: 630 nm±30 nm) was applied.

(3) Appearance 2

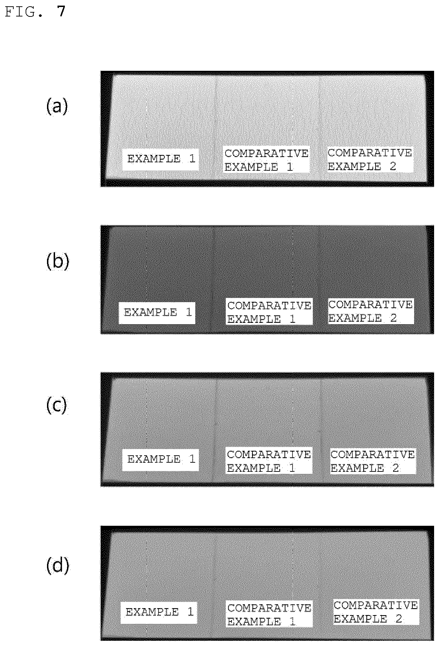

The laminate film of each of Example 1, Comparative Example 1, and Comparative Example 2 was bonded to a transparent glass plate with a pressure-sensitive adhesive to provide a measurement plate. A surface emitting unit (manufactured by AI Tec System Co., Ltd., LED Lighting Box "LLBK1") was arranged in a dark room, and under the state in which the measurement plate was placed on a light emitting surface thereof, the appearance (transmission appearance) of the measurement plate when light was applied from the surface emitting unit at a light control volume of 1 was visually observed. The transmission appearance is shown in each of FIG. **7(a),** FIG. **7(b),** FIG. **7(c),** and FIG. **7(d).** FIG. **7(a)** shows a result when light representing white was applied, FIG. **7(b)** shows a result when blue light (wavelength: 450 nm±30 nm) was applied, FIG. **7(c)** shows a result when red light (wavelength: 630 nm±30 nm) was applied, and FIG. **7(d)** shows a result when green light (wavelength: 530 nm±30 nm) was applied.

As shown in FIG. **6(a),** FIG. **6(b),** and FIG. **6(c),** Example 1 is remarkably excellent in reflection appearance as compared to Comparative Example 1 and Comparative Example 2. In the above-mentioned evaluation, the black acrylic plate was used on the assumption of the combination with an absorption-type polarizing member, but a difference in reflection appearance was able to be observed in the same manner even when the transparent glass plate was used. It is conceived that, according to Example 1, a problem of a ghost that may occur in the display system according to the embodiment of the present invention because of the reflection light can be extremely satisfactorily solved. As shown in FIG. **7(a),** FIG. **7(b),** FIG. **7(c),** and FIG. **7(d),** the transmission appearance does not largely differ among Example 1, Comparative Example 1, and Comparative Example 2.

The present invention is not limited to the above-mentioned embodiments, and various modifications may be made thereto. For example, the configurations described in the above-mentioned embodiments may each be replaced by substantially the same configuration, a configuration having the same action and effect, or a configuration that can achieve the same object.

Industrial Applicability

The lens unit according to the embodiment of the present invention may be used in, for example, a display body such as a pair of VR goggles.

Reference Signs List

**2** display system, **4** lens unit, **12** display element, **14** reflection-type polarizing member, **16** first lens portion, **18** half mirror, **20** first retardation member, **22** second retardation member, **24** second lens portion, **28** absorption-type polarizing member, **30** third retardation member, **31** first protective member, **32** second protective member, **34** laminate film, **36** substrate, **38** surface-treated layer, **41** adhesion layer, **42** adhesion layer, **43** adhesion layer, **44** adhesion layer, **45** adhesion layer, **46** adhesion layer, **100** first laminate portion, **200** second laminate portion.

**Claims**

1.　A lens unit to be used in a display system configured to display an image to a user, the lens unit comprising:

　　a reflection-type polarizing member configured to reflect light, which has been emitted toward a front side from a display surface of a display element configured to display the image, and has passed through a polarizing member and a first λ/4 member;
　　a first lens portion arranged on an optical path between the display element and the reflection-type polarizing member;
　　a half mirror arranged between the display element and the first lens portion, the half mirror being configured to transmit the light emitted from the display element and to reflect the light reflected by the reflection-type polarizing member toward the reflection-type polarizing member;
　　a second lens portion arranged on the front side of the reflection-type polarizing member;
　　a second λ/4 member arranged on an optical path between the half mirror and the reflection-type polarizing member; and
　　a first protective member and a second protective member each arranged on the optical path between the half mirror and the reflection-type polarizing member,
　　wherein the first protective member and the second protective member are arranged to face each other through a space, and
　　wherein the first protective member and the second protective member each have a maximum value for a 5° specular reflectance spectrum in a wavelength range of from 420 nm to 680 nm of 1.2% or less.

2.　The lens unit according to claim 1, wherein the first protective member and the second protective member each have a 5° specular reflectance at a wavelength of 450 nm of 0.3% or less.

3. The lens unit according to claim 1, wherein the first protective member and the second protective member each have a 5° specular reflectance at a wavelength of 600 nm of 0.3% or less.

4. The lens unit according to claim 1, wherein the first protective member and the second protective member each have a surface smoothness of 0.5 arcmin or less.

5. The lens unit according to claim 1, wherein the second $\lambda/4$ member satisfies Re(450)<Re(550).

6. The lens unit according to claim 1, wherein the lens unit comprises:

   a first laminate portion including the second $\lambda/4$ member and the first protective member; and
   a second laminate portion including the reflection-type polarizing member and the second protective member.

7. The lens unit according to claim 6, wherein the second laminate portion includes an absorption-type polarizing member arranged between the reflection-type polarizing member and the second lens portion.

8. The lens unit according to claim 6, wherein the second laminate portion includes a third $\lambda/4$ member arranged between the reflection-type polarizing member and the second lens portion.

9. The lens unit according to claim 8, wherein the third $\lambda/4$ member satisfies Re(450)<Re(550).

10. A laminate film to be used in a display method, the display method comprising the steps of:

   passing light representing an image, which has been emitted through a polarizing member and a first $\lambda/4$ member, through a half mirror and a first lens portion;
   passing the light, which has passed through the half mirror and the first lens portion, through a second $\lambda/4$ member;
   reflecting the light, which has passed through the second $\lambda/4$ member, toward the half mirror with a reflection-type polarizing member;
   enabling the light, which has been reflected by the reflection-type polarizing member and the half mirror, to penetrate through the reflection-type polarizing member with the second $\lambda/4$ member; and
   passing the light, which has penetrated through the reflection-type polarizing member, through a second lens portion,
   wherein the laminate film is arranged on an optical path between the half mirror and the reflection-type polarizing member,
   wherein the laminate film is brought into contact with a space formed between the first lens portion and the second lens portion, and
   wherein the laminate film has a maximum value for a 5° specular reflectance spectrum of 1.2% or less in a wavelength range of from 420 nm to 680 nm.

FIG. 1

FIG. 2

FIG. 3

34

38b } 38
38a }
36

FIG. 4

14a

A
B
A
B
A
B

A
B

Z
Y
X

FIG. 5

FIG. 6

(a)

(b)

(c)

FIG. 7

(a)

EXAMPLE 1    COMPARATIVE EXAMPLE 1    COMPARATIVE EXAMPLE 2

(b)

EXAMPLE 1    COMPARATIVE EXAMPLE 1    COMPARATIVE EXAMPLE 2

(c)

EXAMPLE 1    COMPARATIVE EXAMPLE 1    COMPARATIVE EXAMPLE 2

(d)

EXAMPLE 1    COMPARATIVE EXAMPLE 1    COMPARATIVE EXAMPLE 2

## INTERNATIONAL SEARCH REPORT

| International application No. |
|---|
| **PCT/JP2023/008963** |

### A. CLASSIFICATION OF SUBJECT MATTER

*G02B 27/02*(2006.01)i; *G02B 3/00*(2006.01)i; *G02B 5/00*(2006.01)i; *G02B 5/08*(2006.01)i; *G02B 5/30*(2006.01)i;
*G02B 13/00*(2006.01)i; *G02B 17/08*(2006.01)i; *G02C 7/00*(2006.01)i; *G02F 1/13*(2006.01)i; *G02F 1/1335*(2006.01)i;
*G02F 1/13363*(2006.01)i; *G02F 1/1337*(2006.01)i; *G09F 9/00*(2006.01)i; *H04N 5/64*(2006.01)i; *H04N 5/66*(2006.01)i;
*H04N 13/344*(2018.01)i; *H04N 13/346*(2018.01)i; *H05B 33/02*(2006.01)i; *H05B 33/10*(2006.01)i; *H05B 33/24*(2006.01)i;
*H10K 50/00*(2023.01)i; *H10K 50/858*(2023.01)i; *H10K 50/86*(2023.01)i; *H10K 59/00*(2023.01)i; *H10K 59/10*(2023.01)i
FI:   G02B27/02 Z; G02B3/00 Z; G02B5/00 Z; G02B5/08 D; G02B5/30; G02B13/00; G02B17/08; G02C7/00; G02F1/13
505; G02F1/1335 510; G02F1/13363; G02F1/1337; G09F9/00 313; H04N5/64 511A; H04N5/66 Z; H04N13/344;
H04N13/346; H05B33/02; H05B33/10; H05B33/14 A; H05B33/24; H10K50/858; H10K50/86; H10K59/00; H10K59/10

According to International Patent Classification (IPC) or to both national classification and IPC

### B. FIELDS SEARCHED

Minimum documentation searched (classification system followed by classification symbols)

G02B27/01; G02B27/02; G02B3/00; G02B5/00; G02B5/08; G02B5/30; G02B13/00; G02B17/08; G02C7/00; G02F1/13;
G02F1/1335; G02F1/13363; G02F1/1337; G09F9/00; H04N5/64; H04N5/66; H04N13/344; H04N13/346; H05B33/02;
H05B33/10; H05B33/24; H10K50/00; H10K50/858; H10K50/86; H10K59/00; H10K59/10

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2019-526075 A (APPLE INC.) 12 September 2019 (2019-09-12) paragraphs [0021]-[0039], fig. 2, 4 | 1-5, 10 |
| A | paragraphs [0021]-[0039], fig. 2, 4 | 6-9 |
| Y | US 2021/0033865 A1 (SHARP KABUSHIKI KAISHA) 04 February 2021 (2021-02-04) paragraph [0041], fig. 6 | 1-5, 10 |
| Y | WO 2021/193416 A1 (DEXERIALS CORP) 30 September 2021 (2021-09-30) paragraphs [0002]-[0006], [0017]-[0021], [0051]-[0060], fig. 1 | 1-5, 10 |
| Y | JP 2005-134713 A (KONICA MINOLTA OPTO INC) 26 May 2005 (2005-05-26) paragraphs [0002]-[0005] | 4 |

☑ Further documents are listed in the continuation of Box C.     ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **20 April 2023** | **09 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2023/008963**

C.    DOCUMENTS CONSIDERED TO BE RELEVANT

| Category* | Citation of document, with indication, where appropriate, of the relevant passages | Relevant to claim No. |
|---|---|---|
| Y | WO 2021/145446 A1 (FUJIFILM CORPORATION) 22 July 2021 (2021-07-22) claim 4, paragraphs [0014], [0023]-[0141], fig. 1-2 | 5 |
| A | JP 2019-053152 A (SEIKO EPSON CORP) 04 April 2019 (2019-04-04) entire text, all drawings | 1-10 |

Form PCT/ISA/210 (second sheet) (January 2015)

**INTERNATIONAL SEARCH REPORT**
Information on patent family members

International application No.

**PCT/JP2023/008963**

| Patent document cited in search report | | | Publication date (day/month/year) | Patent family member(s) | | | Publication date (day/month/year) |
|---|---|---|---|---|---|---|---|
| JP | 2019-526075 | A | 12 September 2019 | US<br>paragraphs [0022]-[0040], fig. 2, 4<br>WO<br>EP<br>AU<br>KR | 2018/0039052<br><br>2018/026633<br>3479164<br>2017307221<br>10-2019-0020826 | A1<br><br>A1<br>A1<br>A1<br>A | |
| US | 2021/0033865 | A1 | 04 February 2021 | (Family: none) | | | |
| WO | 2021/193416 | A1 | 30 September 2021 | US<br>paragraphs [0003]-[0011], [0027]-[0033], [0082]-[0095], fig. 1<br>CN<br>KR<br>KR | 2022/0244429<br><br>113728251<br>10-2021-0134762<br>10-2022-0146474 | A1<br><br>A<br>A<br>A | |
| JP | 2005-134713 | A | 26 May 2005 | (Family: none) | | | |
| WO | 2021/145446 | A1 | 22 July 2021 | US<br>claim 4, paragraphs [0078], [0096]-[0450], fig. 1-2<br>CN | 2022/0373729<br><br>114945856 | A1<br><br>A | |
| JP | 2019-053152 | A | 04 April 2019 | US<br>entire text, all drawings<br>CN | 2019/0079234<br><br>109507801 | A1<br><br>A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021103286 A
- JP 2014010291 A
- JP 2014026266 A
- JP 2015212816 A
- JP 2015212817 A
- JP 2015212818 A
- JP 2006163343 A
- JP 2006178389 A
- WO 2018123551 A1
- JP 2002333642 A
- JP 2008088309 A
- JP 2012073580 A
- JP 6470455 B